# EUROPEAN PATENT APPLICATION

(11) **EP 4 171 179 A1**
(43) Date of publication of application: **26.04.2023**
(21) Application number: 21829849.5
(22) Date of filing: 01.06.2021
(51) Int. Cl.: H05K 1/11

(54) **PRINTED CIRCUIT BOARD AND ELECTRONIC DEVICE WITH PRINTED CIRCUIT BOARD**

(30) Priority: 24.06.2020 CN 202010595816
(71) Applicant: ZTE Corporation, Shenzhen, Guangdong 518057 (CN)
(72) Inventor: XIE, Zhifen, Shenzhen, Guangdong 518057 (CN); LI, Qin, Shenzhen, Guangdong 518057 (CN); YU, Haidan, Shenzhen, Guangdong 518057 (CN); ZHANG, Jian, Shenzhen, Guangdong 518057 (CN)
(74) Representative: Savi, Massimiliano
(86) International application number: PCT/CN2021/097790
(87) International publication number: WO 2021/259021

(57) **Abstract**

Disclosed are a printed circuit board and an electronic device with the printed circuit board. The printed circuit board (100) comprises a substrate (200), wherein the substrate (200) is provided with a connection footprint (210); at least two differential signal hole pairs (300) are arranged on the connection footprint (210), and the at least two differential signal hole pairs (300) form a signal hole matrix; at least two first connection hole groups (400) are arranged on the connection footprint (210), and the at least two first connection hole groups (400) and the at least two differential signal hole pairs (300) are arranged spaced apart from each other; and a connection line between a first signal hole (310) and a second signal hole (320) in each differential signal hole pair (300) forms an acute angle with a connection line between a first connection hole (410) and a second connection hole (420) in each first connection hole group (400).

## Description

### CROSS-REFERENCE TO RELATED APPLICATION

The present disclosure is filed on the basis of Chinese Patent Application No. 202010595816.9 filed June 24, 2020, and claims priority to the Chinese Patent Application, the entire contents of which are incorporated present disclosure herein by reference.

### TECHNICAL FIELD

Embodiments of the present disclosure relate to, but are not limited to, the technical field of electronics, and in particular, to a printed circuit board and an electronic device with the printed circuit board.

### BACKGROUND

Electrical connectors for high-speed transmission are usually used in communication devices, networks, servers, data storage, and other systems. In general, it is easier and more cost-effective to manufacture the aforementioned systems into electronic components such as printed circuit boards (PCBs). The aforementioned separate electronic components may allow two printed circuit boards to be interconnected using an electrical connector. A known way for connecting several printed circuit boards is to use one printed circuit board as a backplane and connect the other printed circuit boards (called mainboards or daughter cards) through the backplane. Another known way is to connect two printed circuit boards using an orthogonal connector instead of a backplane.

With the increasing demand for data transmission bandwidth, higher requirements are put forward for the density of terminals of a connector, making the connector to be more complex in function. At present, the press-fit technique is widely applied in the market to connect an electrical connector for high-speed transmission with a PCB. In order to form electrical connection to a conductive trace or a ground/power plane, this technique requires perforation of the PCB, and press-fit pins of the connector are connected into PCB holes through interference fit. The PCB includes signal vias and ground vias. These vias (also called "through holes") are filled or plated with metal, such that the through holes are electrically connected to the press-fit pins through one or more planes or conductive electrical traces through which the through holes run.

In the interconnection of an electrical connector system, the electrical performance of the system partially depends on a connecting footprint of an electrical connector of a printed circuit board (including the structures of conductive traces, ground planes and through holes in the printed circuit board). The layout and design of a PCB are complex, especially for high-speed and high-density electrical connectors and their footprints on the circuit board.

At present, the following problems are common in the design of PCB footprints of existing connectors. First, due to the limited routing space, it is difficult to adopt differential pair routing for outgoing lines from signal vias, and single-ended lines have to be routed for a certain length before being coupled to generate differential signals, which will lead to asymmetry of internal differential intra-pair routing, resulting in deterioration of insertion loss, return loss, SDC, skew and other indicators. Second, in order to ensure that differential intra-pair routing is of equal length, one line will be wound in a big circle while the other line will be wound in a small circle, resulting in a large arc of an external signal line. As a result, signals will run faster on the external signal line, leading to a great skew.

### SUMMARY

The following is a summary of the subject matter described in detail herein. This summary is not intended to limit the protection scope of the claims.

Embodiments of the present disclosure propose a printed circuit board and an electronic device with the same.

In accordance with an aspect of the disclosure, an embodiment provides a printed circuit board. The printed circuit board includes a substrate, at least two differential signal via pairs and at least two first connecting via groups. The substrate has a connecting footprint. The at least two differential signal via pairs are arranged in the connecting footprint, the differential signal via pair includes a first signal via and a second signal via, and the at least two differential signal via pairs form a signal via matrix. The at least two first connecting via groups are arranged in the connecting footprint, the at least two first connecting via groups and the at least two differential signal via pairs are spaced from each other, and the first connecting via group includes a first connecting via and a second connecting via. A connecting line between the first signal via and the second signal via in each of the differential signal via pairs making an acute angle with a connecting line between the first connecting via and the second connecting via in each of the first connecting via groups.

In accordance with another aspect of the disclosure, an embodiment provides an electronic device. The device includes the printed circuit board according to the embodiment described above.

Other features and advantages of the present disclosure will be set forth in the following specification, and will partially become apparent from the description, or may be understood by practicing the present disclosure. The objective and other advantages of the present disclosure can be achieved and obtained by the structure particularly specified in the description, the claims and the accompanying drawings.

### BRIEF DESCRIPTION OF DRAWINGS

The accompanying drawings are used to provide a further understanding of the technical scheme of the present disclosure and constitute a part of the description. The accompanying drawings are used to illustrate the technical scheme of the present disclosure in conjunction with the embodiments of the present disclosure, and are not intended to constitute a limitation to the technical scheme of the present disclosure.
FIG. 1 is a schematic diagram of a printed circuit board according to Embodiment one of the present disclosure;
FIG. 2 is a schematic diagram of a printed circuit board according to Embodiment two of the present disclosure;
FIG. 3 is a schematic diagram of a printed circuit board according to Embodiment three of the present disclosure;
FIG. 4 is a schematic diagram of a printed circuit board according to Embodiment four of the present disclosure; and
FIG. 5 is a schematic diagram of a printed circuit board according to Embodiment five of the present disclosure.

### DETAILED DESCRIPTION

In order to make the objective, technical scheme and advantages of the present disclosure clear, the present disclosure will be further described in detail below with reference to the accompanying drawings and embodiments. It should be understood that the specific embodiments described herein are merely used to illustrate the present disclosure, and are not intended to limit the present disclosure.

It should be noted that although functional modules have been divided in the schematic diagrams of the device and logical orders have been shown in the flowcharts, in some cases, the modules may be divided in a different manner, or the steps shown or described may be executed in an order different from the orders as shown in the flowcharts. The terms "first", "second" and the like in the specification, the claims, and the accompanying drawings are used to distinguish similar objects, and are not necessarily used to describe a specific order or a precedence order.

Electrical connectors for high-speed transmission are usually used in communication devices, networks, servers, data storage, and other systems. In general, it is easier and more cost-effective to manufacture the aforementioned systems into electronic components such as printed circuit boards (PCBs). The aforementioned separate electronic components may allow two printed circuit boards to be interconnected using an electrical connector. A known way for connecting several printed circuit boards is to use one printed circuit board as a backplane and connect the other printed circuit boards (called mainboards or daughter cards) through the backplane.

With the increasing demand for data transmission bandwidth, higher requirements are put forward for the density of terminals of a connector, making the connector to be more complex in function. At present, the press-fit technique is widely applied in the market to connect an electrical connector for high-speed transmission with a PCB. In order to form electrical connection to a conductive trace or a ground/power plane, this technique requires perforation of the PCB, and press-fit pins of the connector are connected into PCB holes through interference fit. The PCB includes signal vias and ground vias. These vias (also called "through holes") are filled or plated with metal, such that the through holes are electrically connected to the press-fit pins through one or more planes or conductive electrical traces through which the through holes run.

In the interconnection of an electrical connector system, the electrical performance of the system partially depends on a connecting footprint of an electrical connector of a printed circuit board (including the structures of conductive traces, ground planes and through holes in the printed circuit board). The layout and design of a PCB are complex, especially for high-speed and high-density electrical connectors and their footprints on the circuit board.

At present, the following problems are common in the design of PCB footprints of existing connectors. First, due to the limited routing space, it is difficult to adopt differential pair routing for outgoing lines from signal vias, and single-ended lines have to be routed for a certain length before being coupled to generate differential signals, which will lead to asymmetry of internal differential intra-pair routing, resulting in deterioration of insertion loss, return loss, SDC, skew and other indicators. Second, in order to ensure that differential intra-pair routing is of equal length, one line will be wound in a big circle while the other line will be wound in a small circle, resulting in a large arc of an external signal line. As a result, signals will run faster on the external signal line, leading to a great skew.

The embodiments of the present disclosure will be further set forth below with reference to the accompanying drawings.

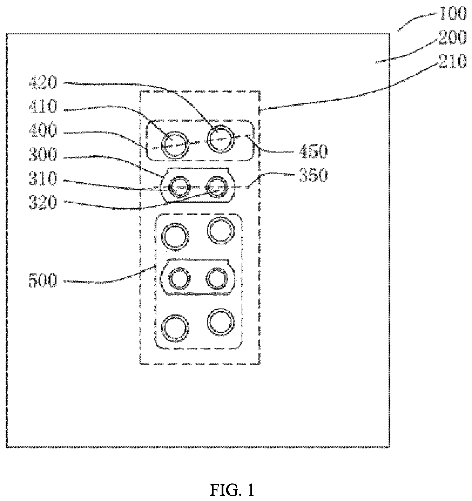

In FIG. 1, a schematic diagram of a printed circuit board according to an embodiment of the present disclosure is shown.

In an example shown in FIG. 1, the printed circuit board 100 includes a substrate 200 and differential signal via pairs 300 and first connecting via groups 400 arranged in the substrate 200. The substrate 200 is a substrate with one or more layers, the differential signal via pairs 300 and the first connecting via groups 400 at least partially run through the substrate, and a connecting footprint 210 is arranged on the substrate 200.

The connecting footprint 210 is provided with at least two differential signal via pairs 300, and the embodiment in FIG. 1 takes two differential signal via pairs 300 as an example. The differential signal via pair 300 includes a first signal via 310 and a second signal via 320, and the two differential signal via pairs 300 form a 2 × 2 signal via matrix.

The connecting footprint 210 is further provided with at least two first connecting via groups 400, and the embodiment of FIG. 1 takes three first connecting via groups 400 as an example. The three first connecting via groups 400 and the two differential signal via pairs 300 are spaced from each other. The first connecting via group 400 includes a first connecting via 410 and a second connecting via 420. A connecting line between the first signal via 310 and the second signal via 320 in each differential signal via pair 300 forms an acute angle with a connecting line between the first connecting via 410 and the second connecting via 420 in each first connecting via group 400. As shown in FIG. 1, a first connecting line 350 between the first signal via 310 and the second signal via 320 forms an acute angle with a second connecting line 450 between the first connecting via 410 and the second connecting via 420 in each first connecting via group 400.

In the embodiment, since the first connecting via groups 400 and the differential signal via pairs 300 are spaced from each other and the connecting line between the signal vias of the differential signal via pair 300 forms an acute angle with the connecting line between the ground vias of the first connecting via group 400, the first connecting via groups 400 are inclined relative to the differential signal via pairs 300, and routing areas therebetween are wide on one side and narrow on the other side. Consequently, differential outgoing lines from the ground vias can be arranged on the wide side, and the large outgoing line space at the wide side also makes it easier to ensure the symmetry of the two signal paths, keep differential tight coupling and help achieve equal-length routing, thus better controlling skew.

It can be understood that the first connecting via groups 400 may be used as ground vias or press-fit vias for a connector.

In addition, because the first connecting via 410 and the second connecting via 420 are staggered from each other, the first connecting via 410 and the second connecting via 420 can be arranged farther apart, which brings greater convenience for the design of the electrical connector without causing the space occupied by the connecting footprint 210 to become larger.

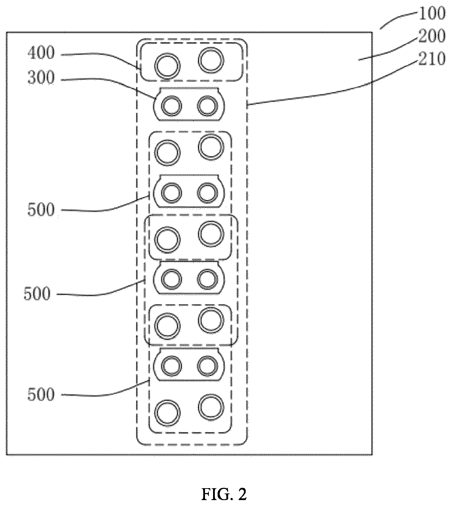

In an embodiment, referring to FIGS. 1 and 2, the differential signal via pair 300 and adjacent first connecting via groups 400 on both sides thereof form a signal via group 500. The connecting footprint 210 includes a plurality of signal via groups 500, and two adjacent signal via groups 500 share one first connecting via group 400. In one signal via group 500, the first connecting via groups 400 on both sides of the differential signal via pair 300 surround the differential signal via pair 300 to provide electrical shielding, so as to ensure that signals of the differential signal via pair 300 are free from interference. Since two adjacent signal via groups 500 share one first connecting via group 400, unnecessary space occupation caused by the arrangement of too many first connecting via groups 400 is avoided, ensuring the utilization rate of the space of the printed circuit board 100.

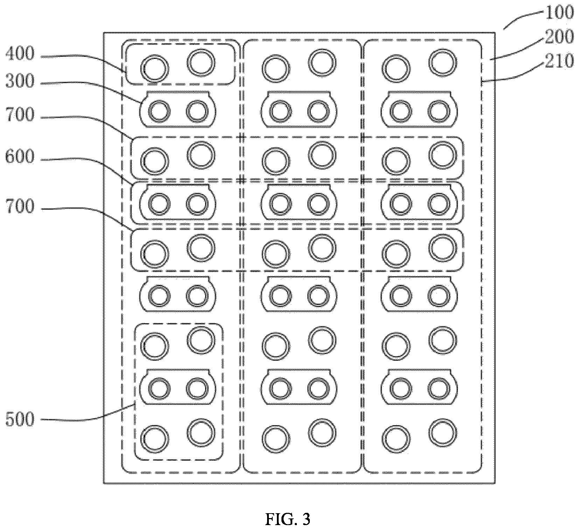

In an embodiment, referring to FIG. 3, a plurality of connecting footprints 210 are arranged on the substrate 200, and the differential signal via pairs 300 in two adjacent connecting footprints 210 are arranged in correspondence. In an embodiment, a plurality of differential signal via pairs 300 are horizontally aligned to form signal via rows 600, and correspondingly, a plurality of first connecting via groups 400 are horizontally aligned to form connecting via rows 700. There are connecting via rows 700 on both an upper and a lower side of each signal via row 600 to provide electrical shielding for the signal via row 600.

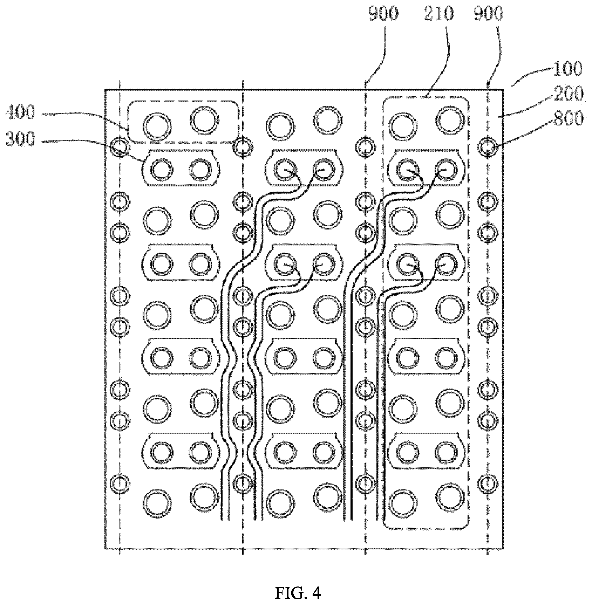

In an embodiment, referring to FIG. 4, the printed circuit board 100 is further provided with a plurality of third connecting vias 800, which are arranged into second connecting via groups 900, and the second connecting via groups 900 are arranged on both sides of each connecting footprint 210. It can be understood that the third connecting vias 800 may be used as both ground vias and press-fit vias for the connector. If the third connecting vias 800 are used as ground vias, the second connecting via groups 900 are arranged on both sides of the connecting footprint 210 to shield signal interference between two adjacent connecting footprints 210. If the third connecting vias 800 are used as press-fit vias for the connector, a better shielding effect can be provided for the connector, thereby ameliorating crosstalks between different columns and eliminating crosstalk resonance between diagonal signal pairs.

Two adjacent connecting footprints 210 share a same second connecting via group 900. Such an arrangement eliminates an excessive provision of the second connecting via groups 900 in the substrate 200, thereby avoiding a waste of the space of the substrate 200.

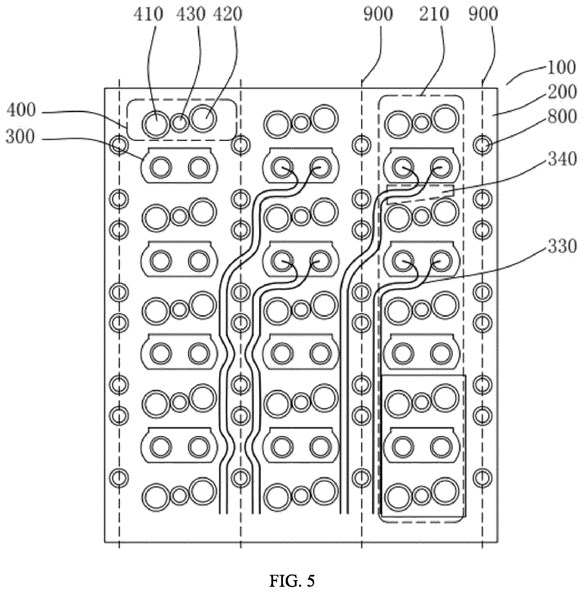

In an embodiment, referring to FIG. 5, a fourth connecting via 430 is arranged between the first connecting via 410 and the second connecting via 420 in each first connecting via group 400, which can further improve the electrical shielding effect of the first connecting via group 400. The size of the fourth connecting via 430 may be set as needed. For example, if the space between the first connecting via 410 and the second connecting via 420 is small, the fourth connecting via 430 may be set to be small.

In an embodiment, the acute angle formed by the connecting line between the signal vias of the differential signal via pair 300 and the connecting line between the ground vias of the first connecting via group 400 is greater than 0 degrees and less than 45 degrees. The larger the acute angle is, the farther apart the first connecting via 410 and second connecting via 420 of the first connecting via group 400 has to be staggered, leading to a large space occupation, and a decreased utilization rate of the space of the printed circuit board 100, which is not conducive to the reduction of the area of the printed circuit board 100. In contrast, limiting the acute angle to be greater than 0 degrees and less than 45 degrees can not only meet the requirement of providing a space for the outgoing lines, but also ensure the utilization rate of the space of the printed circuit board 100.

In an embodiment, referring to FIG. 5, the printed circuit board 100 further includes signal traces 330 electrically connected to the differential signal via pairs 300, a routing area 340 is formed between the differential signal via pair 300 and the first connecting via group 400 which are adjacent, and the signal traces 330 extend from the routing area 340 to the differential signal via pair 300. The first connecting via group 400 is inclined relative to the differential signal via pair 300, so that the routing area 340 therebetween is wide on one side and narrow on the other side. The routing area 340 in FIG. 5 is approximately trapezoidal, or may also be considered to be approximately triangular. It can be understood that the signal traces 330 extend from the wide side of the routing area 340 to the differential signal via pair 300, which makes it easier to ensure the symmetry of the two signal paths and help achieve equal-length routing, thus better controlling skew.

Referring to FIG. 5, the signal traces 330 extend from between two adjacent connecting footprints 210 to the edge of the substrate 200. The signal trace 330 may be completely included in one connecting footprint 210; or may be partially included in one connecting footprint 210 and partially included in an adjacent connecting footprint 210; or when there is a gap or space between two adjacent connecting footprints 210, may be arranged in the gap or space. In addition, if there are both the signal traces 330 and the second connecting via group 900 between two adjacent connecting footprints 210, the second connecting via group 900 may be arranged between multiple groups of signal traces 330 to shield interference between the signal traces 330.

According to another aspect of the present disclosure, an embodiment further provides an electronic device, including the printed circuit board described in the above embodiments. The device includes, but not limited to, a communication device requiring high-speed transmission, such as a router, a data storage unit, a server, a mobile phone, a tablet or a cellphone. A printed circuit board of the communication device is connected to an electrical connector through the connecting footprints 210, so as to implement high-speed data transmission with other electronic devices.

According to the scheme provided by the embodiments of the present disclosure, since the first connecting via groups and the differential signal via pairs are spaced from each other and the connecting line between the signal vias of the differential signal via pair forms an acute angle with the connecting line between the ground vias of the first connecting via group, the first connecting via groups are inclined relative to the differential signal via pairs, such that routing areas therebetween are wide on one side and narrow on the other side. Consequently, differential outgoing lines from the ground vias can be arranged on the wide side, and the large outgoing line space also makes it easier to ensure the symmetry of the two signal paths and help achieve equal-length routing, thus better controlling skew.

The embodiments of the present disclosure have been described in detail above, but the present disclosure is not limited thereto. Those having ordinary skills in the art can also make various equivalent modifications or replacements without departing from the protection scope of the present disclosure, and these equivalent modifications or replacements shall be included in the protection scope defined by the claims of the present disclosure.

## Claims

1. A printed circuit board, comprising:
a substrate, having a connecting footprint;
at least two differential signal via pairs, arranged in the connecting footprint, each of the differential signal via pairs comprising a first signal via and a second signal via, and the differential signal via pairs forming a signal via matrix; and
at least two first connecting via groups, arranged in the connecting footprint, the at least two first connecting via groups and the at least two differential signal via pairs being spaced from each other, and the first connecting via group comprising a first connecting via and a second connecting via; and a connecting line between the first signal via and the second signal via in each of the differential signal via pairs forms an acute angle with a connecting line between the first connecting via and the second connecting via in each of the first connecting via groups.

2. The printed circuit board of claim 1, wherein a differential signal via pair and adjacent first connecting via groups on both sides of the differential signal via pair form a signal via group, the connecting footprint comprises a plurality of signal via groups, and two adjacent signal via groups share one first connecting via group.

3. The printed circuit board of claim 1, wherein the substrate has a plurality of connecting footprints, and the differential signal via pairs in two adjacent connecting footprints are arranged in correspondence.

4. The printed circuit board of claim 3, further comprising a plurality of third connecting vias, wherein the plurality of third connecting vias are arranged into second connecting via groups, and the second connecting via groups are arranged on both sides of each of the connecting footprints.

5. The printed circuit board of claim 4, wherein two adjacent connecting footprints share a same second connecting via group.

6. The printed circuit board of claim 1, further comprising a fourth connecting via arranged between the first connecting via and the second connecting via in each of the first connecting via groups.

7. The printed circuit board of claim 1, wherein the acute angle is greater than 0 degree and less than 45 degrees.

8. The printed circuit board of claim 1, further comprising signal traces electrically connected to the differential signal via pairs, and a routing area formed between the differential signal via pair and the first connecting via group adjacent, the signal traces extending from the routing area to the differential signal via pair.

9. The printed circuit board of claim 8, wherein the signal traces extend from between two adjacent connecting footprints to the edge of the substrate.

10. An electronic device, comprising the printed circuit board of any one of claims 1 to 9.
